# EUROPEAN PATENT APPLICATION

(11) **EP 1 204 305 A2**
(43) Date of publication of application: **08.05.2002**
(21) Application number: 01124954.7
(22) Date of filing: 19.10.2001
(51) Int. Cl.: H05K 3/20, H05K 1/18

(54) **Device comprising an electrical circuit carried by a carrier element and method for the manufacture of such a device**

(30) Priority: 03.11.2000 DE 10054541
(71) Applicant: Tyco Electronics AMP GmbH, 64625 Bensheim (DE)
(72) Inventor: Amman, Norbert, 82067 Kloster Schaeftlarn (DE); Preyss, Walter, 80804 Munich (DE)
(74) Representative: Heinz-Schäfer, Marion

(57) **Abstract**

A device includes an electrical circuit carried by a carrier element, an electrically conductive structure being provided on a surface of the carrier element. In accordance with the invention the one or more components of the electrical circuit are arranged on the side of the electrically conductive structure facing the carrier element (T).

Such a device is more versatile in use and can be made more compact than is the case with conventional arrangements.

A method of producing such a device comprises the following steps:
- application of the electrically conductive structure to a temporary substrate (TS),
- mounting of further components of the electrical circuit on the electrically conductive structure,
- application of a composition forming the carrier element (T) to the side of the temporary substrate carrying the said circuit parts, and
- removal of the temporary substrate.

## Description

The present invention relates to a device comprising an electrical circuit carried by a carrier element, an electrically conductive structure being provided on a surface of the carrier element, and to a method for the manufacture of such a device.

Such a device is, for example, a component manufactured using the thin-film technique. Such a component may consist of:
- a plate-shaped carrier element generally referred to as the substrate and normally consisting of ceramics, silicon or glass,
- an electrically conductive structure applied to the carrier element using the thin-film technique, strictly speaking to the surface of a specific side of the carrier element, wherein this electrically conductive structure can be of one or more layers, and wherein this electrically conductive layer can form:
   - strip conductors,
   - passive components, such as resistors, coils and capacitors,
   - active components, for example, transistors,
   - first contact points (pads) for creating a connection with components to be mounted on the carrier element, such as, for example, one or more semiconductor chips and/or additional or other components, and
   - second contact points (pads) for creating a connection with input and/or output terminals contained in the housing of the arrangement (for connection of the arrangement to other components of the system containing the arrangement),
- components optionally mounted on the carrier element and connected with the first contact points, and
- a housing enclosing the said components and comprising the already mentioned input and/or output terminals of the arrangement.

As is known, devices of that kind enable any desired electrical circuits to be accommodated in a relatively simple manner in very little space.

Such devices cannot be used for all applications however. For example, it is impossible, or possible only with disproportionately great effort, to construct an inductive sensor using such a device. Although the construction of the coils to be provided to detect magnetic fields would not present problems (this can be done by suitable construction and arrangement of the electrically conductive structure), the position of the second contact points already mentioned above and/or the course of the connecting leads connected thereto, normally in the form of bonding wires, to the input and/or output terminals of the arrangement, and possibly also the position of the input and /or output terminals, present difficulties. There are two reasons for this: on the one hand the environment of the part of the electrically conductive circuit forming the coil(s) must be free from electrically conductive materials (otherwise mirror-image currents impairing the function of the sensor can develop), and on the other hand the course of the connecting leads can impose constraints on the placement of the sensor (in particular it can happen that the sensor, or more accurately, the coils contained therein, cannot be placed as close to the magnetic field source as desired).

So far, no method of eliminating the said problems, at any rate no method that does not involve unreasonable effort, has been found.

The present invention is therefore based on the problem of developing the device and the method defined above such that devices of this kind can be more versatile in use.

This problem is solved in accordance with the invention by a device which is characterised in that one or more further components of the electrical circuit are arranged on the side of the electrically conductive structure facing the carrier element.

Such a device consisting of "further components" of the electrical circuit enables the second contact points mentioned above, normally formed by pads, to be replaced by other connecting means, such as, for example, by electrical connectors or by contact elements suitable for soldering the arrangement onto an electrical printed circuit board, such as contact pins for example; these connecting means can be arranged independently of the position of the remainder of the electrical circuit at any desired points within the arrangement and can consequently be contactable, for example, even from the underside of the carrier element.

Even inductive sensors or other electrical circuits that could not previously be produced using the thin-film technique, or could only be produced with constraints, can now be produced using the thin-film technique.

Moreover, a device constructed as claimed can also be of smaller and more compact construction than is the case with conventional arrangements.

Specifically, the said connecting means can be constructed so that they can be connected directly, that is, without diversion via input and/or output terminals provided in a housing of the arrangement, to other components of the system containing the arrangement, whereby the provision of the input and/or output terminals and of the housing or housing part carrying them can be omitted. Moreover, electrical components that were previously arranged on the electrically conductive structure on the side thereof remote from the carrier element can also be shifted into the carrier element, whereby the area of the arrangement can be reduced.

A method according to the invention is characterised by the steps:
- application of the electrically conductive structure to a temporary substrate,
- mounting further components of the electrical circuit on the electrically conductive structure,
- applying a composition forming the carrier element to the side of the temporary substrate carrying the said circuit parts, and
- removal of the temporary substrate,
and represents an especially simple option for manufacturing a device of the present invention.

Advantageous further developments of the invention can be derived from the subsidiary claims, the following description and the Figures.

The invention is explained in more detail hereinafter on the basis of exemplary embodiments and with reference to the drawings, in which:
Figure 1 shows the construction of an exemplary embodiment of a device according to the invention, and
Figures 2A to 2C show different stages in the manufacture of the device shown in Figure 1.

The device described in the following concerns an inductive sensor. It should be pointed out at this juncture, however, that the characteristics of the arrangement described in detail below can be used also in any other arrangements that comprise an electrical circuit carried by a carrier element with an electrically conductive structure provided on a surface of the carrier element.

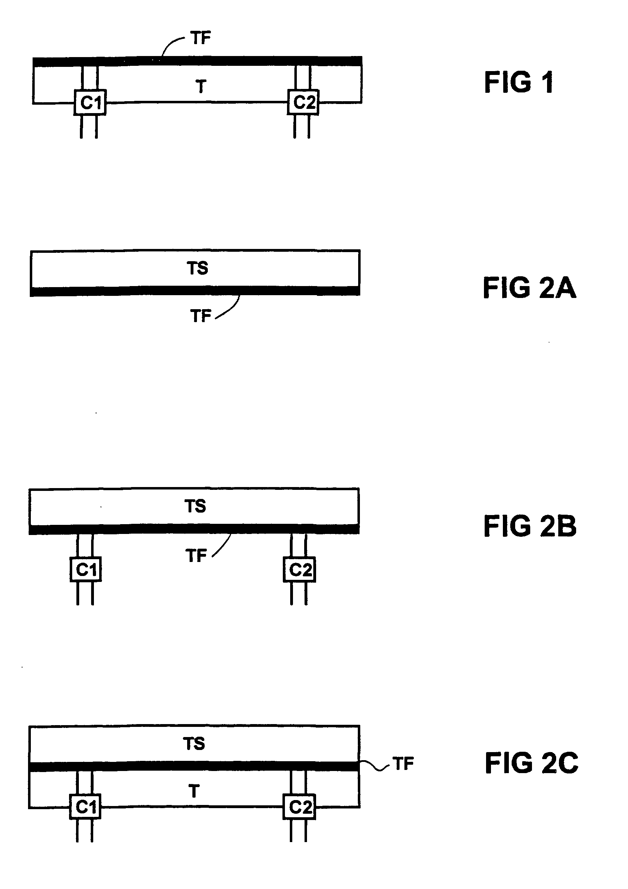

The device of which the construction and manufacture are described in detail below is shown in Figure 1. It consists of:
- a plastics material carrier element T, which in the example under consideration has a thickness between 1 mm and 2 mm, but can also be thicker or thinner as required,
- applied to the carrier element T, or more accurately to the surface of a side of the carrier element T, an electrically conductive structure formed by a single-layer or multi-layer thin film TF and forming one or more coils,
- two electrical connectors C1 and C2 in the form of SMT components, which are soldered onto the electrically conductive structure and are so embedded in the carrier element T that they are contactable from the side of the carrier element remote from the electrically conductive structure.

Such a device can be manufactured especially easily when the procedure as described below with reference to Figures 2A to 2C is followed.

The starting point of the manufacture is a temporary substrate TS, which in the example under consideration is a plate-shaped element consisting of metal. A single-layer or multi-layer thin film TF is applied to this temporary substrate TS; if the thin film is a multi-layer thin film, the individual thin film layers are applied in a sequence that is opposite to the sequence in which the layers are arranged on the carrier element T of the finished component (shown in Figure 1). The resulting intermediate product is illustrated in Figure 2A.

The electrical connectors C1 and C2, which, as already mentioned above, are SMT components, are then soldered onto specifically provided contact points of the electrically conductive structure formed by the thin film TF. The resulting intermediate product is illustrated in Figure 2B.

The temporary substrate TS, or more accurately, the side of the same carrying the electrically conductive structure, and parts of the electrical connectors C1 ands C2 are subsequently potted or encapsulated in a composition that in the cured state forms the carrier element T of the finished component (shown in Figure 1). The resulting intermediate product is illustrated in Figure 2C.

The temporary substrate TS is then removed (for example, by etching the same away). This results in the finished component shown in Figure 1.

The device shown in Figure 1 can also in principle be manufactured in other ways and its method of manufacture is not limited to the one described here.

Regardless of its manner of manufacture, the device shown in Figure 1 has the advantages:
- that its construction is better adaptable to particular conditions (it is more versatile in use), and
- that it can be made smaller and more compact than is the case with conventional devices of this kind.

It will be understood that these advantages can also be achieved when:
- the electrically conductive structure TF is formed not, as in the example under consideration, by a thin-film structure, but using other materials and/or techniques, for example, by a thick-film structure, by electrically conductive foils (laminated onto the temporary substrate), a small printed circuit board or multi-layer ceramics,
- additional components or components other than coils, or simply electrical strip conductors, are realised by the electrically conductive structure TF,
- in addition or as an alternative to the electrical connectors, further or other connecting devices for connecting the arrangement to other components of the system containing the arrangement, for example, pins that can be used for soldering the arrangement onto an electrical printed circuit board, are mounted on the side of the electrically conductive structure TF facing the carrier element T,
- in addition or as an alternative to the connecting devices, other components, such as, for example, resistors, capacitors, coils, transistors, semiconductor chips etc., are mounted on the side of the electrically conductive structure TF facing the carrier element T,
- the components of the electrical circuit mounted on the side of the electrically conductive structure TF facing the carrier element T are constructed and/or are mounted in a manner other than described above, and/or
- the temporary substrate TS consists of a material other than metal, for example, glass or ceramics.

A device constructed as described, irrespective of the details of practical realisation and manufacture thereof, can be constructed to be smaller and more compact and is more versatile in use than is the case with the conventional device of this kind. In addition when the described manufacturing process is used, the arrangement can also be manufactured very easily.

It will be understood by those skilled in the art that the present invention is not limited to the embodiments shown and that many additions and modifications are possible without departing from the scope of the present invention as defined in the appending claims.

## Claims

1. Device comprising an electrical circuit carried by a carrier element (T), an electrically conductive structure being provided on a surface of the carrier element, **characterised in that** one or more further components of the electrical circuit are arranged on the side of the electrically conductive structure facing the carrier element.

2. Device according to claim 1, **characterised in that** the carrier element (T) consists of plastics material.

3. Device according to claim 1 or 2, **characterised in that** the components of the electrical circuit arranged on the side of the electrically conductive structure facing the carrier element are fully or partly embedded in the carrier element (T).

4. Device according to any one of the preceding claims, **characterised in that** the electrically conductive structure comprises a single-layer or multi-layer thin-film structure (TF).

5. Device according to any one of the preceding claims, **characterised in that** the electrically conductive structure comprises a single-layer or multi-layer thick-film structure.

6. Device according to any one of the preceding claims, **characterised in that** the electrically conductive structure comprises one or more single-layer or multi-layer electrically conductive films.

7. Device according to any one of the preceding claims, **characterised in that** the electrically conductive structure is arranged and constructed so that it forms passive and/or active electronic components.

8. Device according to any one of the preceding claims, **characterised in that** the electrically conductive structure is arranged and constructed so that it forms strip conductors connecting specific points on the surface of the carrier element (T) with one another.

9. Device according to any one of the preceding claims, **characterised in that** components of the electrical circuit are also arranged on the side of the electrically conductive structure remote from the carrier element (T), said components preferably being adhesively secured or soldered on said structure.

10. Device according to any one of the preceding claims, **characterised in that** the components of the electrical circuit arranged on the side of the electrically conductive structure facing the carrier element (T) comprise active or passive components, preferably one or more semi-conductor chips.

11. Device according to any one of the preceding claims, **characterised in that** the components of the electrical circuit arranged on the side of the electrically conductive structure facing the carrier element (T) comprise one or more connecting devices for electrical connection of the arrangement to other components of the system containing the arrangement, said connecting devices preferably comprising one or more electrical connectors (C1, C2).

12. Device according to claim 11, **characterised in that** the connecting devices comprise one or more contact elements suitable for soldering the arrangement onto an electrical printed circuit board.

13. Device according to any one of the preceding claims, **characterised in that** the components of the electrical circuit arranged on the side of the electrically conductive structure facing the carrier element (T) are elements designed for surface mounting, said elements preferably being elements soldered onto or adhesively secured to the side of the electrically conductive structure facing the carrier element.

14. Method for manufacture of a device with an electrical circuit carried by a carrier element (T) and having an electrically conductive structure provided on a surface of the carrier element, **characterised by** the steps:
a) application of the electrically conductive structure to a temporary substrate (TS),
b) mounting of further components of the electrical circuit on the electrically conductive structure,
c) application of a composition forming the carrier element ( T) to the side of the temporary substrate carrying the said circuit parts, and
d) removal of the temporary substrate.

15. Method according to claim 14, **characterised in that** application of the electrically conductive structure to the temporary substrate (TS) comprises application of a single-layer or multi-layer thin-film structure (TF) to the temporary substrate.

16. Method according to claim 14, **characterised in that** application of the electrically conductive structure to the temporary substrate (TS) comprises application of a single-layer or multi-layer thick-film structure to the temporary substrate.

17. Method according to claim 14, **characterised in that** application of the electrically conductive structure to the temporary substrate (TS) comprises application of one or more single-layer or multi-layer electrically conductive films to the temporary substrate.

18. Method according to any one of claims 14 to 17, **characterised in that** application of the electrically conductive structure to the temporary substrate (TS) is effected such that the layer structure of the electrically conductive structure is opposite to the layer structure of the electrically conductive structure present in the finished arrangement on the carrier element (T).

19. Method according to any one of claims 14 to 18, **characterised in that** mounting of the further components of the electrical circuit on the electrically conductive structure is effected by adhesion or soldering.

20. Method according to any one of claims 14 to 19, **characterised in that** application of the composition forming the carrier element (T) is effected by casting or injection-moulding plastics material around the components of the electrical circuit provided on the temporary substrate (TS).

21. Method according to any one of claims 14 to 20, **characterised in that** removal of the temporary substrate (TS) is effected by etching away of the same.

22. Method according to any one of claims 14 to 21, **characterised in that** after removal of the temporary substrate (TS) further components of the electrical circuit are mounted on the side of the electrically conductive structure remote from the carrier element (T).
